Europäisches Patentamt

European Patent Office

Office européen des brevets

(11) Publication number: **0 408 258 A2**

# EUROPEAN PATENT APPLICATION

(21) Application number: 90307381.5

(22) Date of filing: 04.07.90

(51) Int. Cl.5: **H01L 39/24**

(30) Priority: 14.07.89 US 379992

(43) Date of publication of application:
16.01.91 Bulletin 91/03

(84) Designated Contracting States:
AT BE DE FR GB IT NL SE

(71) Applicant: **GENERAL ATOMICS**
**10955 John Jay Hopkins Drive**
**San Diego California 92121-1194(US)**

(72) Inventor: **Chin, Jack**
**2437 Unicornio Street**
**Carlsbad, California 92009(US)**
Inventor: **Liang, Samuel Shu-Kiang**
**4644 Benhurst Avenue**
**San Diego, California 92112(US)**
Inventor: **Woolf, Lawrence D.**
**7920 Corte Cardo**
**Carlsbad, California 92009(US)**

(74) Representative: **Coxon, Philip et al**
**Eric Potter & Clarkson St. Mary's Court St.**
**Mary's Gateate**
**Nottingham NG1 1LE(GB)**

(54) Aqueous coprecipitation methods for producing high temperature superconducting materials.

(57) Methods and compositions for producing materials which exhibit high temperature superconductivity. The material produced using the present invention is high in purity and is able to exhibit superconductivity at temperatures above those obtainable by liquid nitrogen. The present invention discloses techniques for fabricating ceramic superconducting materials of the type having the general chemical formula $MBa_2Cu_3O_{7-x}$, using an aqueous coprecipitation process.

According to the teachings of the present invention, the metal components of the superconducting material are first placed in solution. The ratios of the various components are carefully chosen so that the final product has the desired stoichiometric ratio.

The solution pH is adjusted by the addition of a basic solution which contains only volatile components. That is, pH is adjusted in such a manner that the pH adjustment does not leave residue of any type in the final superconducting product after the product is heated, sintered, or calcined. Accordingly, ammonium hydroxide, ammonia gas and urea are generally preferred for adjusting the pH.

EP 0 408 258 A2

The present invention relates to methods for producing superconducting materials and, more specifically to high temperature superconducting materials and methods for their fabrication. More particularly, the present invention relates to high temperature superconducting materials fabricated in such a manner as to be substantially free from contaminants and such that the pH during the fabrication process is closely controlled in order to avoid particle agglomeration and in order to increase the homogeneity of the material.

Superconducting ceramics are often produced by mixing powders together and then sintering them to form a crystalline substance having superconductive properties. However, it is very difficult to provide mixing at a molecular level, using solid mixing techniques, to produce a homogeneous solid because of the long diffusion times required.

Certain other types of vapour processes have been developed for the production of superconducting materials. These include evaporation and sputtering processes. Evaporation requires coevaporation of three materials and sputtering requires cosputtering of three materials. In both cases the processes are complex and the equipment needed for these procedures is expensive.

It has also been found that superconducting materials can be produced by a coprecipitation process. Generally, the necessary components are dissolved in aqueous or organic solvents. Conditions are then adjusted so that a superconducting material will form when the precipitate is calcined and sintered. It is found, however, that when organic solvents are used the resulting precipitate includes a significant amount of the solvent and/or the precipitating agent that may be present in solution. The presence of carbon-containing contaminants, for example, can cause the formation of $BaCO_3$ nd other impurities. These and other dissolved impurities may severely disrupt the resulting crystalline structure of the final product. This disruption may prevent the material from becoming superconductive, cause the material to be superconductive only at very low temperatures, or prevent the material from carrying commercially useful currents.

A critical requirement of the coprecipitation processes is the control of pH. Proper pH control is necessary in order to obtain homogeneous materials and to control particle agglomeration. In order to maintain the pH of the solution within desirable ranges, it is generally necessary to add acids or bases to control pH. These substances may also form compounds with impurities in solution which can inhibit the formation of desired superconducting material.

A particular problem has been encountered in known processes when using bases that form complexes with copper in solution. One technique used in sol gel preparation of 1-2-3 type material to prevent the copper complex formation is to treat the precipitate with lithium.. The treatment with lithium, however, itself adds a trace of lithium to the precipitate. Therefore, it is then necessary to attempt to remove the lithium from the precipitate. Thus, the addition of any unnecessary component to the solution during precipitation greatly increases the complexity of the process.

In summary, it can be seen that most materials, other than those needed to form the precipitate, will pollute or contaminate the resulting product. It is thus preferable to use only those materials that can be easily removed, such as volatile components removable by heating, in the coprecipitation process. Organic solvents and the like are found to become incorporated within the resulting superconductive material. It is therefore desirable to avoid using organic materials in the precipitation process. Likewise, many acids and bases used to control pH in existing processes are also found in the resulting precipitate and are not easily removed. These contaminants adversely affect the chemical composition of the superconductive material.

In order to produce an acceptable high temperature superconductor for most applications, it is necessary for it to have high critical current density. This is also produced, in part, by a regular grain-to-grain crystalline contact of less than the coherence length (approximately 15 Angstroms in ceramic superconductors). If such a grain-to-grain structure does not exist, the critical current density of the material will be significantly decreased. It will be appreciated from the discussion above that one way to minimise the grain-to-grain contact distance of polycrystalline materials is to minimise the contaminants in the material. Contaminants are usually found at the grain boundaries and will thus increase the grain-to-grain contact distance.

It is an object of this invention to provide an improved process for producing a superconducting material.

According to one aspect of the invention there is provided a method for producing a superconducting material comprising the steps of:
forming a solution comprising M, barium and copper; and
adjusting the pH of said solution such that a precipitate comprising M, barium and copper is formed.

According to another aspect of this invention there is provided a method for producing high temperature superconducting materials which are substantially free of contaminants, comprising the steps of:

(a) obtaining an aqueous solution of M, copper, and barium wherein said solutions are substantially free of other nonvolatile species;

(b) mixing said solutions of M, copper, and barium together;

(c) adjusting the pH of the resulting mixture without the addition of any substantial quantities of nonvolatile components, such that a substantially uniform precipitate forms; and

(d) recovering and drying said precipitate such that substantially all volatile contaminants are removed.

According to another aspect of this invention there is provided a method for producing high temperature superconducting materials, comprising the steps of:

(a) obtaining an aqeuous solution of M, wherein M is chosen from the group consisting of yttrium and the rare earth elements;

(b) obtaining an aqueous solution of barium;

(c) obtaining an aqueous solution of copper;

(d) combining the M, barium and copper solutions in such proportions that the mole ratios of M to barium to copper comprises approximately 1:2:3; and

(e) adjusting the pH of the mixed solution upwardly until a precipitate forms.

According to another aspect of this invention there is provided a method for producing a superconducting material, comprising the steps of:

(a) obtaining quantities of M, barium, and copper such that the mole ratio of M to barium to copper is approximately 1:2:3;

(b) forming a solution of said M, barium, and copper, which solution is substantially free of other nonvolatile species; and

(c) adjusting the pH of said solution such that a precipitate comprising M, barium, and copper is formed, which precipitate comprises a precursor of a high temperature superconducting material.

The present invention solves the problems identified above with respect to the production of superconducting materials. The present invention provides methods and compositions for producing materials which exhibit high temperature superconductivity. The material produced using the present invention is high in purity and is able to exhibit superconductivity at temperatures above those obtainable by liquid nitrogen.

The material of the present invention is produced in solution. Thus, the difficult procedures and complex apparatus required to produce superconductive materials by other techniques are not needed. The present invention teaches the use of water as a solvent throughout the process. At the same time, the present invention teaches the use of pH control within the solution without the addition of nonvolatile foreign species to the final superconducting material.

More particularly, the present invention discloses techniques for fabricating ceramic superconducting materials of the type which may have the general chemical formula $MBa_2Cu_3O_{7-x}$, using an aqueous coprecipitation process, where M is preferably yttrium or a rare earth element and x is preferably between approximately 0 and approximately 0.5.

According to the teachings of the present invention, the metal components of the superconducting material are first placed in solution. The solutions which are used are preferably nitrates, hydroxides and oxides, or other similar compounds. Nitrates are preferred because of the fact that the resulting nitrogen residues are easily driven out of the resulting precipitate by simple heating of the product. It will be appreciated, however, that any form of the required components that leave only volatile residue in the final product will be acceptable. For example, various oxides may be used. Accordingly, a highly pure, high temperature superconducting material is obtained.

Preferably, yttrium nitrate, or other rare earth compound, is obtained in solution. At the same time, copper nitrate and barium nitrate solutions are preferably prepared. The three components are then combined into a single solution. The ratios of the various components are carefully chosen so that the final product has the desired stoichiometric ratio. The desired ratio of yttrium to barium to copper is 1:2:3, or possibly slightly off stoichiometrically so as to avoid liquid phases which occur between 900 - 1000 ˚C and would leave a non-superconducting coating on the grain boundaries.

It is generally observed that the metal solutions combined have a fairly low pH. In addition, acid may be required in solution in order to dissolve the starting materials. At this low pH, precipitation occurs slowly, if at all. At the same time, the precipitate may exhibit certain undesirable traits such as particle agglomeration. Accordingly, with a preferred embodiment, it is necessary to adjust the pH to the solution mixture upwardly in order to produce the desired precipitated product.

According to the present invention the solution pH is adjusted preferably by the addition of ammonia gas or a basic solution which contains only volatile components. That is, it is desirable to adjust the pH in such a manner that the pH adjustment does not leave residue of any type in the final superconducting product after the product is heated, sintered or calcined. Accordingly, ammonia gas, ammonium hydroxide and urea are generally preferred for adjusting the pH. All of these compounds leave a volatile residue that can easily be recovered through heating.

3

It is generally found that ammonium hydroxide raises the pH very quickly resulting in quick precipitation of the final product. Urea and ammonia gas, conversely, raise the pH more slowly. Indeed, it is generally desirable to heat the urea solution for a fairly substantial period of time, possible even days, before the solution pH begins to rise appreciably. Preferably the solution is heated to a temperature in the range of from approximately 90° C to approximately 100° C, the boiling point of the solution. At a particular point in this extended heating process, the superconducting material will begin to precipitate out. Thus, using urea, it is easy to control the uniformity of the precipitate in that all of the materials can be mixed together thoroughly before any significant amount of the precipitate forms.

Once the precipitate forms, it can be recovered from the solution. The precipitate can then be dried at a slightly elevated temperature using conventional techniques. The drying temperature is generally sufficient to drive off any volatile solution components that may remain within the precipitate. Thus, at the end of the drying stage, a highly pure material is left.

Following the drying stage, other processing steps may take place. For example, the precipitate may be sintered and/or calcined in order to obtain particular ceramic qualities. These steps also assure that any remaining traces of the volatile solution components are driven off.

Accordingly, it is a primary advantage of the present invention that it provides methods for producing a high temperature superconducting material which is extremely high in purity.

It is a related advantage of the present invention that it produces a high purity superconducting material using solution chemistry by a process which avoids the difficulties encountered in producing superconducting material by other techniques.

It is a further advantage of the present invention that it provides methods for producing a superconducting material using solution chemistry without the necessity of adding non-volatile contaminants into the solution.

It is a related advantage of the present invention that it uses water as a solvent and to closely control the pH using volatile species which do not contaminate the final superconducting material.

Accordingly, the present invention is a major advancement in the art in that it provides high temperature superconducting materials which are extremely high in purity. It is another advancement in the art that the present invention produces such high purity superconducting materials using solution chemistry in order to avoid the difficulties encountered in producing superconductors by other techniques. It is a further advancement in the art that the present invention provides superconducting materials using solution chemistry without the necessity of adding contaminents into the solution which are not easily removable from the final product. Specifically, it is an advancement in the art that the present invention uses water as a solvent and closely controls the pH without adding nonvolatile species which pollute the superconducting material.

The present invention relates to improved methods for producing high temperature superconducting materials employing solution chemistry. In particular, the present invention relates to the formation of a precipitated compound having the general formula $MBa_2Cu_3O_{7-x}$, where M is yttrium or a rare earth element and x is between approximately 0 and approximately 0.5.

As mentioned above, one of the primary problems encountered in the art has been the development of methods for producing ceramic superconducting materials using convenient techniques, while leaving no residue or other pollutant materials within the superconducting ceramic. Using the teachings of the present invention, these problems are solved. Convenient and easy to use solution processing techniques are used while still providing a high purity precipitated product.

The process of the present invention begins by obtaining solutions of the necessary components. These solutions contain no other species that are not easily removed by heating of the final precipitated product. For the purpose of this discussion, solution components that are removable from the superconducting product by heating will be referred to as being "volatile".

Thus, in one preferred embodiment of the present invention, the necessary metals are dissolved from their nitrate form. This is because of the fact that nitrates are generally volatile and can be driven off by heat. Other forms of compound metal may also be dissolved to obtain these solutions, such as oxides. Indeed, any form of the metal compound which can be dissolved in solution and which contains no unwanted species that are not volatile would be acceptable.

Using techniques known in the art of solution chemistry, three solutions of known concentration are obtained. These include a solution of rare earth or yttrium (the M) component, the barium component and the copper component. These solutions are monitored and tested by conventional techniques so that the concentration of the solutions can be carefully controlled. Once the desired quantities of the stock solutions have been obtained, the solutions are simply mixed together in the proper proportions.

Chemical composition control comes through the preparation of stock nitrates or other solutions of the starting metal cations. Special precautions are taken to minimise trace elements and carbon dioxide contamination in both the water used and the source of chemicals. These analysed values are then used to determine the chemical compositions of the mixed nitrate solutions.

As was mentioned above, the components are mixed such that the molar ratio between the rare earth or yttrium, barium, and copper is approximately 1:2:3. This results in a final precipitated product having the correct stoichiometric ratio between the various components. Mixing preferably takes place at slightly elevated temperatures. For example, temperatures in the 90°C to 100°C range have been found acceptable.

Chemical contaminents are avoided in the final product by using target material cations and anions in solution which, with the exception of the components of the precipitated product, decompose into volatile components when heated. No foreign nondecomposable ions are allowed into the high purity source material. These volatile components are subsequently removed from the precipitate, as will be discussed below, by heating the co-precipitated product until the volatile contaminants are evolved from the precipitate.

Once the various components have been dissolved, it is observed that the pH of the solution is in the acidic range. For example, pH in the 1 to 3 range is typical of the initial solution mixture. In order to produce a precipitate having the desired characteristics, and to allow the precipitate to come out of solution at an acceptable rate, it is necessary to increase the solution pH. As was mentioned above, control of pH has been a problem in solution processing of superconducting ceramics in that the pH control often required the addition of foreign species which would then become incorporated as contaminants in the final product. The present invention, however, teaches the control of pH with volatile basic solutions. Three chemicals that are presently preferred include ammonium hydroxide, ammonia gas and urea.

pH control is generally necessary in order to control agglomeration behaviour of the co-precipitated material and the uniformity of the co-precipitated product. When using ammonium hydroxide or ammonia gas, as discussed above, the precipitate of $MBa_2Cu_3O_{7-x}$, hydroxides of rare earth or yttrium and barium are observed even at room temperature. The copper may remain in solution as a complex copper ammonium ion. However, when the solution temperature is raised to the range of from approximately 90°C to solution boiling, and the solution is allowed to loose water, the copper ammonium complex becomes less stable relative to a mixed hydroxide of yttrium, barium, and copper, and a dark precipitate is formed. Thus, the final product can be obtained when this precipitate is dried, heated to decompose the remaining nitrates, and then calcined.

By contrast, urea releases hydroxyl ion more slowly in solution. Barium and yttrium hydroxide are precipitated when the temperature is raised to release the hydroxyl ion. A copper urea complex ion is also formed by at 90-100°C. It also decomposes in preference to the 1:2:3 material when the solution is allowed to loose water. Thus, all three materials appear to be co-precipitated. The use of ammonia gas or urea thus potentially improves the uniformity of the co-precipitation product by minimising the need for cation diffusion and by allowing atoms of the co-precipitated materials to mix on an atomic scale while still in solution.

Once the precipitate is obtained, it is dried at elevated temperatures. One preferred method is to continuously stir the precipitated product while heating it to the range of from approximately 90°C to solution boiling. Heating and stirring continues until an essentially dry product is recovered. Most of the solution species that are not part of the desired co-precipitation product are decomposed and driven off during this drying step.

After drying, it may be desirable to remove further excess water or any remaining volatile species, and to fix the material. This can be accomplished by calcining. One calcining procedure that has been found to be acceptable is to heat the dried precipitate to between approximately 750°C and approximately 925°C in air or oxygen for approximately one half hour (0.5) to four (4) hours. The nitrates and other volatile components are driven off in this calcining step. This step also allows the precipitate to stabilise while minimising degradation of the product.

Once the product has been dried and calcined, it may be desirable to sinter the material. During the sintering and cooling, oxygen is allowed to diffuse into the material, fixing the oxygen content and crystal structure of the product. Sintering may take place at from approximately 800°C to approximately 1020°C in the presence of oxygen. It will be appreciated that a sintering temperature above the point at which barium carbonate is stable is preferred in order to remove any traces of barium carbonate found within the precipitate. This temperature is typically approximately 900°C or above.

Thus, it will be appreciated that the sintering and calcining steps help to remove any remaining volatile impurities. Indeed, even traces of essentially non-volatile impurities, such as carbonates, may also be driven off.

While sintering above approximately 900° C removes impurities from the product, it also depletes the oxygen content of the material below that which is needed to produce the high temperature superconducting material. This oxygen is then replaced either by slowly cooling to approximately 400° C in oxygen, or by cooling to approximately 450° C, then maintaining that temperature for an extended period in an oxygen environment. This low temperature step stabilises the orthorhombic structure. The orthorhombic phase is the desired superconducting phase of the $MBa_2Cu_3O_{7-x}$ material.

In summary, the method of producing the high temperature superconducting material comprises the following steps: (a) obtaining aqueous solutions of M, copper, and barium wherein those solutions are substantially free of nonvolatile contaminants; (b) mixing said solution of M, copper, and barium together; (c) adjusting the pH of the resulting mixture using a solution substantially free of nonvolatile components such that a substantially uniform precipitate is formed; and (d) recovering and drying said precipitate such that substantially all volatile components are removed.

One of the very significant features of the present invention is its ability to form a very pure final product. Purity is assured by avoiding the introduction of any nonvolatile species, other than those that form the final product. Thus, no contaminants are found within the superconducting material in that no potentially contaminating materials are used during the process. The results of the process are superconducting materials having superconducting properties well within the range of liquid nitrogen, and indeed, up to approximately 95° K.

As was discussed above, the superconducting material formed by the above process has the chemical formula $MBa_2Cu_3O_{7-x}$, where M may be yttrium or any selected rare earth element. The selected rare earth elements (lanthanide series) include lanthanum, neodymium, samarium, europium, gadolinium, dysprosium, holmium, erbium, thulium, ytterbium, and lutetium. Any of the above elements may be substituted for yttrium to form the composition of the present invention.

## EXAMPLES

The following examples are given to illustrate the methods and compositions of the present invention but are not intended to limit the scope of the present invention.

## Example 1

This example describes a method for forming a high purity, high temperature superconducting composition within the scope of the present invention.

Initially, a 0.5 molar solution of $Y(NO_3)_3$ in water was prepared. The pH at this concentration was determined to be 5.12. A precipitate began to be formed when the pH was adjusted to approximately 5.42 with ammonium hydroxide.

2 ml of the $Y(NO_3)_3$ solution in water was obtained having a pH of 6.08. This solution was slightly cloudy when the pH was adjusted to 7.3 with ammonium hydroxide.

7.7 ml of $Ba(OH)_2$ solution saturated at 23° C was added to the $Y(NO_3)_3$ solution described above and pH was adjusted to 12.02. At this point, discrete colloidal particles in the solution were observed.

0.9 ml of 1 M $Cu(NO_3)_2$ solution was added to the barium and yttrium solution described above at pH 9.04. The precipitate remained colloidal in a dark blue solution.

When this final solution mixture was heated to approximately 90° C the solution turned dark with colloidal precipitate being formed and settling to the bottom. pH was observed at 8.29. The precipitate was then recovered and dried by heating on a hot plate while continuously stirring. The resulting precipitate resulted in high temperature superconducting ceramic material having the chemical formula $YBa_2Cu_3O_{7-x}$.

## Example 2

This example describes the preparation of a high purity, high temperature superconducting material, within the scope of the present invention.

Initially, the following components were dissolved in a dilute nitric acid solution to form an initial solution mixture containing nitrate ions plus:

| Component | Amount |
|---|---|
| $Y_2O_3$ (Aldrich Lot No. 80810HT) | 2.8 gm |
| CuO (Mallinckrodt Lot No. KLNZ) | 6.0 gm |
| BaO | 7.6 gm |
| $H_2O$ | 300 ml |

A 13.5 M solution of urea was added to the initial solution mixture until the pH reached 7.0. Mixing occurred at approximately 100° C for approximately two hours. A precipitate formed at this point which was then recovered when the slurry was dried on a hot plate as in Example 1. The resulting dried precipitate was then calcined at 650° C for one hour in air.

This procedure resulted in a precursor powder from which was formed a high temperature superconducting material within the scope of the present invention having the chemical formula $YBa_2Cu_3O_{7-x}$.

Example 3

This example describes the preparation of a high purity, high temperature superconducting material within the scope of the present invention.

In this example, 200 ml of a stock solution of yttrium nitrate was obtained. A 0.5 M yttrium nitrate stock solution was prepared. At the same time, 344 ml of a 1.0 M copper nitrate stock solution, was also prepared. 47.32 grams of barium ion contained within a barium nitrate solution was also obtained. All three stock solutions were combined to form an initial solution mixture. The resulting solution was neutralised with ammonium hydroxide.

After neutralisation, a precipitate formed which was then recovered and dried using the hot plate drying technique described in Example 1. The precipitate was then calcined in air at 850° C for 15 hours and then recalcined in air at 830° C for 15 hours.

The resulting product was found to have the formula $YBa_2Cu_3O_{7-x}$ and was found to be substantially free from impurities upon x-ray analysis. The material was found to be a high temperature superconducting material.

Example 4

This example describes the preparation of a high purity, high temperature superconducting material within the scope of the present invention.

In this example 50 ml of a 0.5 M stock yttrium nitrate solution was mixed with 90 ml of a 1.0 M stock copper nitrate solution. Finally, 11.83 gm of barium ion from barium nitrate was added to the solution. The three solutions were mixed and pH was adjusted with ammonium hydroxide. The initial pH of the mixture was approximately 2.93 and the adjusted pH approximately 6.42.

A precipitate was observed, slurry dried and the powder was recovered. The resulting precipitate was dried using the technique of Example 1 and calcined in air at 650° C for 1 hour. The result was a high temperature preoxide superconducting material having the chemical formula $YBa_2Cu_3O_{7-x}$.

Example 5

In this example, a method for forming a high purity, high temperature superconducting composition within the scope of the present invention is illustrated. The composition has the chemical formula $YBa_2Cu_3O_{7-x}$.

In this example, the same stock solutions as those described in Example 4 were obtained. 50 ml of yttrium solution was combined with 81 ml of copper solution. Finally, 12.3 g of barium ion in a barium

7

nitrate solution was added to form an initial solution mixture. The pH was then adjusted by adding 8.5 gm of urea to the solution and warming the mixture. The precipitate was observed upon heating the mixture to approximately 100°C for several hours.

The precipitate was dried on a hot plate then calcined at 825°C in air for one hour and then recalcined at 825°C in air for 15 hours. The product was also sintered at approximately 870°C.

The product was analysed by conventional x-ray analysis and also by differential thermal analysis. It was found that a highly consistent, high purity superconducting material was obtained using this process.

## Example 6

This example describes a method for forming a high purity, high temperature superconducting composition within the scope of the present invention. The composition has the general chemical formula $YBa_2Cu_3O_{7-x}$.

Yttrium oxide with 5.65 gm of yttrium plus barium nitrate with 26.134 gm of barium and copper oxide with 11.933 gm of copper were dissolved in a liter of distilled water containing 30 ml of concentrated nitric acid.

Following mixing of the yttrium, barium, and copper, 18 gm of urea was added to adjust the pH. The solution was heated to approximately 100°C for several hours. At this point a precipitate was formed. The slurry was then dried. The resulting precipitate was calcined in air for 15 hours at 850°C.

X-ray analysis revealed that a highly pure, superconducting ceramic had been formed. The superconducting ceramic had the chemical formula $YBa_2Cu_3O7-x$.

## Example 7

This example describes a method for forming a high purity, high temperature superconducting composition within the scope of the present invention. The composition has the chemical formula $DyB_2Cu_3O_{7-x}$.

In this example, a solution containing 9.35 gm of dysprosium from dysprosium oxide dissolved in water was added to 26.135 gm of barium from a barium nitrate solution and 11.933 gm of copper ion from copper oxide dissolved in an acid solution.

The resulting solution was heated then neutralised with 18 g of urea and a precipitate of presuperconducting material was obtained. The precipitate was then recovered and calcined at 850°C in air for 15 hours and then recalcined at 900°C in air for five (5) hours.

X-ray analysis and differential thermal analysis both revealed that a highly pure superconducting material had been formed having the chemical formula $DyBa_2Cu_3O_{7-x}$.

## Example 8

This example describes a method for forming high purity, high temperature superconducting composition within the scope of the present invention. The composition has the chemical formula $ErBa_2Cu_3O_{7-x}$.

A solution was prepared by combining 9.35 gm of $Er_2O_3$ with 11.933 gm of CuO. 52 ml of concentrated $HNO_3$ and 100 ml of $H_2O$ were added to form a stock solution. At the same time, 26.134 gm of $Ba(NO_3)_2$ was added to 200 ml of water. The $Ba(NO_3)_2$ solution was then thoroughly mixed with the stock solution. The solution was neutralised with 46 ml of 28% $NH_4OH$.

After the solution had been neutralised, a precipitate was immediately observed. The precipitate was recovered and dried using the procedure described in Example 1. The precipitate was then calcined at 850°C for 15 hours and then recalcined at 900°C for five hours.

X-ray analysis revealed a highly pure superconducting ceramic. This was confirmed by differential thermal analysis. The ceramic had the chemical formula $ErBa_2Cu_3O_{7-x}$.

## Example 9

This example describes a method for forming a high purity, high temperature superconducting composition within the scope of the present invention. The composition has the chemical formula $NdBa_2Cu_3O_{7-x}$.

In this example, 8.412 gm of $Nd_2O_3$ was combined with 26.134 gm of $Ba(NO_3)_2$, 11.833 gm of CuO, 30 ml of concentrated nitric acid and 400 ml of water. This solution was then neutralised with 30 ml of 28% ammonium hydroxide and 12 gm of urea. A precipitate was then observed.

The precipitate was recovered, dried and calcined in air at 900°C for 15 hours.

Differential thermal analysis and x-ray analysed confirmed that a highly pure, high temperature superconducting ceramic had been formed. The superconducting ceramic had the chemical formula $NdBa_2Cu_3O7-x$.

## Example 10

This example describes the preparation of a high purity, high temperature superconducting material according to the present invention. The composition has a ratio deliberately differing from the 1:2:3 ratio obtained in the above examples, i.e. $Dy_{1.03}Ba_{1.97}Cu_{2.94}O_{7-x}$.

In this example, a solution containing 19.21 gm of dysprosium from dysprosium oxide dissolved in water was added to 51.486 gm of barium from a barium nitrate solution and 23.388 gm of copper ion from copper oxide dissolved in an acid solution.

The solution was heated and then neutralised with 50 ml of ammonium hydroxide and 60 ml of $HNO_3$. The solution, which was cloudy and bluish, was then heated until it turned dark black. The solution was dried and a precipitate was observed. The precipitate was then recovered and calcined in air at 900°C for six (6) hours, then sintered in air at 900°C for six (6) hours, and then oxygen treated in air at 450°C for one (1) hour.

X-ray analysis and differential thermal analysis both revealed that a highly pure superconducting material had been produced having the chemical formula $Dy_{1.03}Ba_{1.97}Cu_{2.94}O_{7-x}$.

## Example 11

This example describes the preparation of a high purity, high temperature superconducting material within the scope of the present invention.

In this example, 4000 ml of a 1.0 M stock solution of dysprosium nitrate was prepared. Dysprosium nitrate stock solution containing 0.2M of dysprosium was mixed with copper nitrate stock solution containing 0.58 M of copper. 104.54 grams of barium ion contained within a barium nitrate solution was also obtained. All three stock solutions were combined to form an initial solution mixture. The resulting solution was neutralised with ammonia gas to a pH of 8.

After neutralisation, a precipitate formed which was then recovered and dried using the hot plate drying technique described in Example 1. The precipitate was then calcined in oxygen at 800°C for 1 hour and then recalcined in oxygen at 900°C for 3 hours.

The resulting product was found to have the formula $DyBa_2Cu_{2.9}O_{7-x}$ and was found to be substantially free from impurities upon x-ray analysis. The material was found to be a high temperature superconducting material.

## SUMMARY

In summary, the present invention accomplishes all of the objectives set forth above. The present invention provides methods for producing compositions of extremely high purity which are useful as high temperature superconducting materials. The present invention provides methods whereby high temperature superconducting ceramics can be produced using solution chemistry. Thus, the procedures disclosed above minimise non-uniform mixing and multi-phase materials which result from conventional techniques used to produce superconducting materials.

The present invention avoids chemical contaminants during the procedure. This is achieved by adding species to the process which are either volatile, or which make up part of the final product. That is, carbonates, sodium compounds, and other species typically used to adjust pH and solution characteristics, but which would tend to leave nonvolatile residue, are avoided.

It will be appreciated that the present invention provides methods which will be highly useful in the development of superconducting materials, which methods are economically practical. Materials which are super conducting at temperatures achieved using liquid nitrogen are provided. Therefore, the possibility of employing the materials developed using the present invention in common, practical applications is greatly increased. Indeed, it may be readily practical to use there materials in magnets, motors, electrical transmission lines, computers, and other similar applications.

It will be appreciated that the present invention may be embodied in other specific forms without departing from its spirit or essential characteristics. The scope of the invention is, therefore, indicated by the appended claims rather than by the foregoing description. All changes which come within the meaning and range of equivalency of the claims are to be embraced within their scope.

## Claims

1. A method for producing a superconducting material comprising the steps of:
forming a solution comprising M, barium and copper; and
adjusting the pH of said solution such that a precipitate comprising M, barium and copper is formed.

2. A method according to Claim 1 comprising obtaining an initial aqueous solution of M, obtaining an initial aqueous solution of barium and obtaining an initial aqueous solution of copper, and mixing said initial solutions together to form the first mentioned solution.

3. A method according to Claim 2 wherein said initial solutions of M, copper, and barium are nitrate solutions.

4. A method according to Claim 1, 2 or 3 wherein the mole ratio of M to barium to copper is approximately 1:2:3.

5. A method according to any preceding claim wherein M is selected from the group consisting of yttrium and the rare earth elements.

6. A method according to any preceding claim wherein the dried precipitate has the chemical formula $MBa_2Cu_3O_{7-x}$.

7. A method according to Claim 6 wherein x is between approximately 0 and approximately 0.5.

8. A method according to any preceding claim wherein the pH is adjusted by adding a base selected from the group consisting of ammonia gas, urea and ammonium hydroxide.

9. A method according to any of Claims 1 to 7 wherein the pH is adjusted by adding urea and further comprises the step of heating the first mentioned solution to a temperature within the range of from approximately 90°C to approximately the boiling point of the first mentioned solution for a time sufficient for a precipitate to form.

10. A method according to any preceding claim comprising recovering the precipitate.

11. A method according to Claim 10 comprising drying the precipitate.

12. A method according to Claim 10 or 11 further comprising the step of sintering the recovered precipitate.

13. A method according to Claim 10, 11 or 12 further comprising the step of calcining the recovered precipitate.

14. A method according to any preceding claim wherein the pH is adjusted to the range of from approximately 6 to approximately 11.

15. A method according to any preceding claim wherein the superconducting materials exhibit the onset of superconductivity at temperatures between approximately 70°K and approximately 100°K.